# EUROPÄISCHE PATENTSCHRIFT

(11) **EP 1 313 635 B1**
(45) Veröffentlichungstag und Bekanntmachung des Hinweises auf die Patenterteilung: **06.04.2005**
(21) Anmeldenummer: 01983444.9
(22) Anmeldetag: 21.08.2001
(51) Int. Cl.: B60T 8/00

(54) **VORRICHTUNG ZUR FAHRDYNAMIKREGELUNG UND VERFAHREN ZUR ORIENTIERUNG VON FAHRDYNAMIKSENSOREN**
DEVICE FOR REGULATING THE DYNAMICS OF VEHICLE MOVEMENT AND A METHOD FOR ALIGNING VEHICLE-DYNAMICS SENSORS
DISPOSITIF DE REGLAGE DE LA DYNAMIQUE DE TRANSLATION D'UN VEHICULE ET PROCEDE D'ORIENTATION DES CAPTEURS DE LA DYNAMIQUE DE TRANSLATION

(30) Priorität: 22.08.2000 DE 10041206; 18.10.2000 DE 10051811; 09.04.2001 DE 10117640
(43) Veröffentlichungstag der Anmeldung: 28.05.2003
(73) Patentinhaber: Continental Teves AG & Co. oHG, 60488 Frankfurt (DE)
(72) Erfinder: BURGDORF, Jochen, 63075 Offenbach (DE); HAUPT, Karlheinz, 55435 Gau-Algesheim (DE); VOLZ, Peter, 64291 Darmstadt (DE); ZYDEK, Michael, 60529 Frankfurt (DE); HEISE, Andreas, 64546 Mörfelden (DE)
(86) Internationale Anmeldenummer: PCT/EP2001/009656
(87) Internationale Veröffentlichungsnummer: WO 2002/016179

(56) Entgegenhaltungen:
- DE-A- 19 725 058
- DE-A- 19 755 431
- US-A- 5 274 576

## Beschreibung

Die Erfindung betrifft eine Vorrichtung gemäß Oberbegriff von Anspruch 1 und ein Verfahren gemäß Oberbegriff von Anspruch 17.

Die DE 197 55 431 beschreibt ein Fahrdynamikregelungssystem, bei dem ein Sensormodul für Fahrdynamiksensoren, umfassend Gierratensensoren und Beschleunigungssensoren, in einem getrennt von der hydraulischen Steuerung angeordneten elektronischen Gehäuse angeordnet sind, wobei in diesem Gehäuse die Verarbeitung der Sensorsignale verarbeitet werden und die für die Ansteuerung der Hydraulikeinheit benötigten Signale erzeugt werden. Die hydraulische Steuereinheit ist mit dem elektronischen Gehäuse über einen Systembus verbunden.

Eine weitere Vorrichtung zur Fahrdynamikregelung mit einer Anordnung der Fahrdynamiksensoren in einem getrennten Gehäuse beschreibt die DE 198 47 667 A1. Nach der Schrift befinden sich die Fahrdynamiksensoren gemeinsam mit einer CPU für die Bremsenregelung in einem Gehäuse im Bereich der Fahrzeugmitte. Die Leistungselektronik mit den Ventiltreibern ist dagegen in den Bremsenregler integriert, welcher mit der CPU über eine Schnittstelle verbunden ist.

Neben den vorstehend beschriebenen Vorrichtungen mit "verteilter Intelligenz" werden vielfach zur Fahrdynamikregelung (ESP), aber auch für ABS, ASR etc., integrierte Steuergeräte eingesetzt, die raumsparend sind und sich besonders kostengünstig fertigen lassen. Kennzeichnend für diese Art von Steuergeräten ist eine kompakte Bauweise mit einer monolithischen Einheit aus elektronischer Reglereinheit und einem Ventilblock, welche im Motorraum eines Kraftfahrzeugs angeordnet ist. Die Reglereinheit, welche mit Sensoren und Aktuatoren verschiedenster Art, wie Raddrehzahlsensoren, Füllstandsensoren, elektromagnetische Hydraulikventile, Relais und dergleichen verbunden ist, dient im wesentlichen zur Steuerung/Regelung der Bremsen und zum Eingriff in das Motormanagement. Der Ventilblock, welcher mit der Reglereinheit über ein Stecksystem verbunden ist, umfaßt magnetisch zu betätigende hydraulische Ventile zur Ansteuerung der Bremszylinder und einen angeflanschten Pumpenmotor.

Die Fahrdynamiksensorik umfassend Beschleunigungssensoren und mindestens einen Gierratensensor sind heute entweder in Form einzelner Bauelemente oder zusammengefaßt und gehäust in einem getrennt vom integrierten Steuergerät angeordneten Modul mit eigener Prozessorintelligenz (Sensorcluster) im Bereich des Schwerpunktes des Fahrzeugs untergebracht.

Das Anordnen der Fahrdynamiksensoren in einem getrennten Gehäuse mit einem zusätzlichen Mikroprozessor zur Fehlerüberwachung und Busbehandlung kann jedoch auf Grund der hohen Sicherheitsanforderungen bei modernen Bremssystemen nachteilig sein. So ist es möglich, daß der zusätzlich benötigte, im separaten Sensormodul angeordnete, Mikroprozessor oder die benötigte Übertragungseinrichtung ausfällt. Um dies auszuschließen, sind zusätzliche Sicherheitsvorkehrungen zu treffen. Ein weiterer Nachteil ist, daß für das Sensorcluster eine sichere Stromversorgung bereitgestellt werden muß, was ebenfalls aufwendig ist. Darüber hinaus muß das getrennte Gehäuse gegen elektromagnetische Strahlung wirksam abgeschirmt werden, um fehlerhafte Sensorsignale zu vermeiden.

Die Erfindung setzt sich daher zum Ziel, eine besonders zuverlässig und fehlerfrei arbeitende Vorrichtung zur Bremsen- und Fahrdynamikregelung zu schaffen.

Diese Aufgabe wird erfindungsgemäß gelöst durch eine Vorrichtung gemäß Anspruch 1.

Nach der Erfindung werden einige, insbesondere alle Fahrdynamiksensoren, in innerhalb des integrierten Bremsensteuergeräts untergebracht oder daran fixiert. Vorzugsweise werden der oder die Fahrdynamiksensoren in der elektronischen Reglereinheit integriert. Es ist aber auch denkbar, daß die Fahrdynamiksensoren beispielsweise in einer Ausnehmung des Ventilblocks angeordnet werden.

Der Begriff Fahrdynamiksensoren umfaßt nach der Erfindung bevorzugt Drehraten- und Beschleunigungssensoren, wobei deren sensorisch empfindlichen Achsen jeweils bezüglich allen möglichen Raumachsen orientiert sein können. Es kann aber auch zweckmäßig sein, daß bei einer Fahrdynamikregelung lediglich die Drehrate um die Hochachse des Kraftfahrzeugs sensorisch erfaßt wird. Zu den Fahrdynamiksensoren zählen somit auch einzelne Querbeschleunigungssensoren oder Längsbeschleunigungssensoren. Besonders bevorzugt werden von den Drehratensensoren alle drei Raumachsen sensorisch erfaßt.
Es kann aus Gründen des weiter unten beschriebenen Justierverfahrens zweckmäßig sein, nur den oder die Drehratensensoren in einer erfindungsgemäß bevorzugten Baugruppe zusammenzufassen. Die Beschleunigungssensoren können dann entweder direkt auf dem Schaltungsträger der elektronischen Regeleinheit untergebracht sein oder getrennt von der Regeleinheit, z.B. auf einem weiteren Bauteilträger oder in einem getrennten Gehäuse.

Die Fahrdynamiksensoren sind bevorzugt auf einem gemeinsamen Träger angeordnet, welcher elektrisch mit einem Träger für Bauelemente der elektronischen Reglereinheit verbunden ist.

Die Fahrdynamiksensoren sind außerdem zweckmäßigerweise in einem zumindest überwiegend abgeschlossenen Sensorgehäuse untergebracht, welches ggf. zusätzliche weitere elektronische Bauelemente umfassen kann.
Eine weitere erfindungsgemäß bevorzugte Ausführungsform besteht in einer Anordnung der Fahrdynamiksensoren auf dem Bauelementträger der elektronischen Reglereinheit. Diese Möglichkeit besteht dann, wenn eine Beseitigung von Fehlorientierungen der Fahrdynamiksensoren beispielsweise durch eine Justage der gesamten Reglereinheit vorgenommen wird.

Für den Betrieb der Vorrichtung sollten die Fahrdynamiksensoren in der hinsichtlich der Fahrzeugachsen vorgesehenen Lage möglichst genau ausgerichtet sein. Das heißt, daß in Bezug auf die Fahrzeugachsen die Achsen der Sensorelemente in einer weitestgehend exakt definierten Orientierung montiert sein müssen, beispielsweise im einfachsten Fall so, daß die Sensorachsen mit der Längs-, Quer- oder Hochachse des Fahrzeugs zusammenfallen.

Es ist nicht ohne weiteres möglich, die Fahrdynamiksensoren in einem automatischen Fertigungsprozeß für eine erfindungsgemäße Vorrichtung durch eine enge Auslegung der zulässigen Toleranzen lagerichtig zu integrieren. Demgegenüber können die Fertigungskosten gesenkt werden, wenn die Toleranzen erweitert werden und ein bestimmtes Maß an Fehlorientierungen nach dem Zusammenbau in Kauf genommen wird.

Nach einer bevorzugten Ausführungsform der Erfindung ist daher in der Vorrichtung ein Justiermittel vorgesehen, mit dem Fehlorientierungen der Fahrdynamiksensoren nach der Montage der Vorrichtung praktisch vollständig beseitigt werden können.

Eine weitere Ausführungsform löst das Problem, daß Bremsvorrichtungen je nach Fahrzeugtyp in unterschiedlichen Orientierungen montierbar sein müssen. Um für alle Fahrzeugtypen möglichst die gleiche Vorrichtung einsetzen zu können, sind nach einer weiteren bevorzugten Ausführungsform der Erfindung im Gehäuse der Reglereinheit oder dem Bauelementträger Aufnahmemittel vorgesehen, die eine Montage der Fahrdynamiksensoren ohne wesentliche Gehäuse- und/oder Schaltungsträgeränderungen in verschiedenen vordefinierten Einbaulagen in das Bremsensteuergerät ermöglicht.

Das Aufnahmemittel gibt bevorzugt die möglichen Einbaulagen in Form eines Rasters, insbesondere durch eine sternförmige Ausbildung des Rasters, vor. Das Raster kann zweckmäßigerweise als Vertiefung oder Ausnehmung im Gehäuse der Reglereinheit ausgebildet sein.

Die elektronische Reglereinheit nach der Erfindung umfaßt vorzugsweise ein auf einem oder mehren Mikroprozessoren basierendes Regelungssystem, in dem der überwiegende Teil der Regelungsaufgaben für ESP und ABS durchgeführt wird.

Die elektrische Verbindung zwischen Sensorgehäuse oder dem Träger für die Fahrdynamiksensoren und der Vorrichtung zur Fahrdynamikregelung, wobei die Vorrichtung insbesondere eine Leiterplatte für die elektronischen Bauelemente umfaßt, erfolgt bevorzugt mittels elastischer Kontaktelemente. Es ist aber auch möglich, daß zum Anschluß eines solchen Sensormoduls eine Steckverbindung, insbesondere in Form eines Stecksockels, welcher das Sensormodul aufnimmt, vorgesehen ist. Die Kontaktierung mittels elastischer Kontaktelemente kann besonders zweckmäßigerweise in der Weise erfolgen, wie dies bereits für Ventilspulen in der unveröffentlichten deutschen Patentanmeldung DE-A 199 404 61.5 beschrieben ist.

Nach der DE-A 199 404 61.5 werden die Spulen elektrisch mit der Leiterplatte über elastische Kontaktelemente verbunden, wobei die Kontaktelementen bevorzugt druck- und/oder kraftbeaufschlagte Kontaktelemente sind, welche an entsprechend ausgebildeten Kontakten der Leitplatte (z.B. metallisierte Flächen) lösbar anliegen.

Die Kontaktelemente können bevorzugt zusätzlich mittels eines elastischen Elementes oder Mediums in ihrer Position zu den Kontakten beweglich angeordnet sein, wobei entsprechende Elemente zugleich insbesondere auch eine Führung der Kontaktelemente darstellen.

Bei den Kontaktelementen handelt es sich besonders bevorzugt um Federn oder um flexible Leiterfolien, welche insbesondere entweder am Schaltungsträger für die Sensorelemente oder an der Leiterplatte der Reglereinheit unlösbar leitend befestigt sind.

Die Kontaktelemente können im Gehäuse der Reglereinheit oder der Sensorbaugruppe zweckmäßig axial beweglich angeordnet sein.

Die auf der Leiterplatte angeordneten Kontakte sind bevorzugt als flächige elektrisch leitende Kontaktzonen auf dem Leiterplattenmaterial ausgebildet.

Die erfindungsgemäße Kontaktierung ist zur Lagerung der Fahrdynamiksensoren besonders vorteilhaft, da die empfindlichen Sensorelemente hierdurch besonders weich und erschütterungsarm und gleichzeitig sowohl elektrisch sicher befestigt sind.

Das Sensorgehäuse und/oder das Gehäuse der Reglereinheit und/oder die Leiterplatte in der Reglereinheit weist bevorzugt zumindest im Bereich der Sensoren eine elektrische Schirmung auf. Eine Schirmung kann entweder durch eine metallische Beschichtung insbesondere auf dem Gehäusematerial oder durch Einbringen von absorbierendem Material, wie etwa Metallpartikel, in das Gehäusematerial erreicht werden.

Eine zur Schirmung geeignete metallische Beschichtung wird insbesondere dadurch erhalten, daß auf dem Gehäusematerial oder Leiterplattenmaterial eine Metallschicht aufgebracht ist, wobei das Gehäusematerial und das Leiterplattenmaterial zweckmäßigerweise aus einem nichtleitenden Material bestehen.

Eine metallische Schirmung wird besonders bevorzugt dadurch erhalten, daß eine abschirmende Gehäusehutze vorgesehen ist, welche durch Beschichtung der Innenseite eines Gehäusedekkels oder durch Einlegen eines metallischen dosenartigen Körpers entsteht.

Die vorstehend erwähnte Abschirmung kann sich vorzugsweise im Layout der Leiterplatte fortsetzen, so daß ein im wesentlichen geschlossener Schirmmantel um die Fahrdynamiksensoren geschaffen wird. Die Verbindung der Gehäuseschirmung mit der Leiterplattenschirmung läßt sich vorteilhaft durch einen lösbaren Kontakt erzielen.

Zur Vereinfachung der Montage des elektronischen Reglers ist die Leiterplatte mit dem elektronischen Reglergehäuse gemäß einer bevorzugten Ausführungsform mittels Einpreßkontakten verbunden. Einpreßkontakte stellen eine elektrische Verbindung mit den Leiterbahnen der Leiterplatte ohne Löten her und können schnell und sicher maschinell hergestellt werden. Durch eine Vielzahl von Einzelkontakten und geeignet geformte Auflagemittel des Reglergehäuses ergibt sich eine mechanische Fixierung der Leiterplatte ohne zusätzliche Befestigungsmittel ausschließlich durch die vorhandenen Einpreßkontakte.

Nach einer weiteren bevorzugte Ausführungsform handelt es sich bei den justierbaren Befestigungsmitteln um thermisch verformbare Halter, insbesondere um Stäbe.

Augrund des Schutzes der Fahrdynamiksensoren vor Vibrationen können jedoch die elektrischen Verbindungen der Fahrdynamiksensoren mit der Leiterplatte, insbesondere mit der Leiterplatte der Sensoren, zweckmäßigerweise nicht mittels den beschriebenen, die Leiterplatte durchdringenden, Kontaktelementen ausgeführt sein, sondern beispielsweise mittels den weiter oben beschriebenen Federelementen.

In der erfindungsgemäßen Vorrichtung sind in einer bevorzugten Ausführungsform elektronische Filtermittel vorgesehen, welche den unerwünschten Einfluß von Beschleunigungen der Fahrdynamiksensoren, wie z.B. Vibrationen (verursacht durch Pumpenmotor, Ventilbetätigung etc.), unterdrücken. Ein elektronisches Filtermittel läßt sich bevorzugt durch Aufbereitung der Sensordaten mittels analoger oder digitaler Filter realisieren. Die Filterung kann auch innerhalb eines Mikrocontrollers erfolgen.

Die Erfindung betrifft auch ein Verfahren gemäß Anspruch 17 zur Orientierung eines oder mehrerer Fahrdynamiksensoren, bei dem zum Beispiel die Sensordaten von eingebauten Fahrdynamiksensoren mit durch den Fertigungsprozeß hervorgerufenen Fehlorientierungen zunächst während definiert ausgeführter Drehungen gemessen werden und das Ergebnis der Messung dazu genutzt wird, die Fehlorientierung zu korrigieren.

Allgemein betrachtet sind drei Koordinatensysteme wesentlich, welche zueinander fehlorientiert sein können: (1) Das sensorische Koordinatensystem mit den sensorisch empfindlichen Achsen, (2) das Koordinatensystem des fertig zusammengebauten Steuergerätes aus Ventilblock und Reglereinheit und (3) das Koordinatensystem des Fahrzeugs. Ziel der vorzunehmenden Justierung ist es, daß die von der Reglereinheit für die Fahrdynamikregelung benötigten Sensordaten möglichst genau die Drehraten bzw. Beschleunigungen entlang der Fahrzeugachsen wiedergeben.

Die festgelegten Achsen, um die nach dem obigen Verfahren zunächst in festgelegter Weise gedreht oder verschoben wird, sind bevorzugt entweder die Einbauachsen des Steuergeräts oder die Fahrzeugachsen.

Die Korrektur der erfindungsgemäß festgestellten Fehlorientierung erfolgt bevorzugt entweder mit einem weiter oben beschriebenen Justiermittel nach der Erfindung oder mittels Berechnungsschritten im Rechenwerk der elektronischen Reglereinheit, insbesondere durch eine geeignete Software, zur Korrektur der Sensordaten.
So können beispielsweise in einer Lernphase Fehlorientierungen durch das Rechenwerk selbstständig bestimmt und gespeichert werden und in einer späteren Phase im Betrieb der Vorrichtung die in der Lernphase ermittelten Korrekturwerte mit den gemessenen Sensordaten zum Ausgleich der Fehlorientierung verknüpft werden.
Es kann zusätzlich vorgesehen und bevorzugt sein, Erschütterungen und Vibrationen (zum Beispiel verursacht durch die Pumpe oder die Hydraulikventile) auf entsprechende Weise elektronisch durch analoge oder digitale Filterung oder auch mittels einer geeigneten Software aus den Sensorsignalen herauszufiltern, so daß nur noch die fahrdynamisch relevanten Signale durch die Regelungsalgorithmen verarbeitet werden.

Besonders vorteilhaft läßt sich das Verfahren nach der Erfindung ausführen, wenn die Vorrichtung mehr als einen, insbesondere drei Gierratensensoren, z.B. für die Hochachse, die Querachse und die Längsachse, umfaßt.

Die Sensordaten zur Bestimmung der Fehlorientierung, welche während der definierten Drehungen gewonnen werden, können bevorzugt entweder von den Fahrdynamiksensoren direkt stammen oder von zusätzlichen, eigens für die Bestimmung der Fehlorientierung vorgesehenen Sensorelementen.

Mit Hilfe der Erfindung läßt sich vorteilhafterweise auf einen Kabelbaum zum Anschluß der Sensoren verzichten, wodurch eine Vielzahl von durch den Kabelbaum verursachten Fehlerquellen, z.B. Kontaktstörungen bei elektrischen Steckverbindern vermieden werden können. Hierdurch läßt sich auch der Aufwand an aufwendigen Überwachungsschaltungen z.B. zur Kontrolle des Leckstroms, von Übergangswiderständen in externen Steckverbindern und der zusätzlichen mikroprozessorgesteuerten Überwachungstechniken reduzieren.

Weitere bevorzugte Ausführungsformen ergeben sich aus den Unteransprüchen und der nachfolgenden Figurenbeschreibung.

Es zeigen
- Fig. 1: eine erfindungsgemäße Vorrichtung zur Fahrdynamikregelung,
- Fig. 2: eine elektronische Regeleinheit in räumlich schematischer Darstellung,
- Fig. 3: ein integriertes Steuergerät mit Halter zur Justage,
- Fig. 4: ein weiteres Beispiel für eine integrierte Bremsvorrichtung mit integrierten Fahrdynamiksensoren,
- Fig. 5: einen erfindungsgemäßer Träger für die Fahrdynamiksensoren,
- Fig. 6: ein Beispiel für eine justierbare Verbindung von Sensorbaugruppe und Leiterplatte über Einpreßkontakte,
- Fig. 7: eine Ausführungsform einer elektronischen Reglereinheit mit einem Aufnahmemittel,
- Fig. 8: eine elektronische Reglereinheit mit gedämpft eingebautem Sensormodul,
- Fig. 9: eine elektronische Reglereinheit mit eingesetzter Sensorbaugruppe,
- Fig. 10: das Zusammensetzen einer elektronischen Reglereinheit mit einem Ventilblock,
- Fig. 11: ein weiteres Beispiel für die Befestigung eines Sensorträgers an einer Leiterplatte mittels justierbarer Befestigungsmittel,
- Fig. 12: verschiedene Ausführungsbeispiele zur Befestigung eines Sensorträgers mittels stoffschlüssiger Verbindungen und
- Fig. 13: die Befestigung eines Sensorträgers mittels flächiger Lötkontakte.

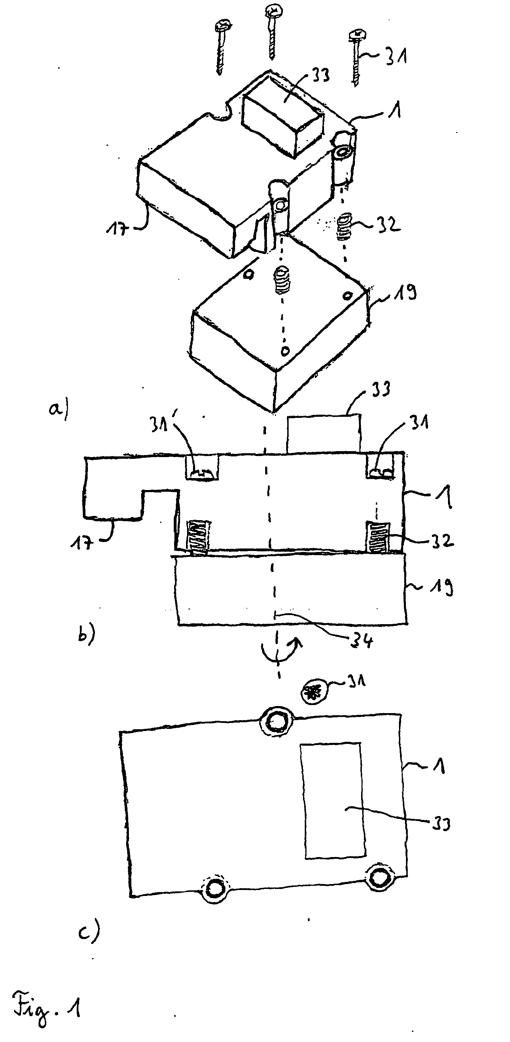

In Fig. 1 ist eine auf einen Ventilblock 19 aufsteckbare elektronische Reglereinheit 1 in räumlicher Darstellung (a)), in Seitenansicht (b)) und in Aufsicht (c)) schematisch dargestellt. Zur Vereinfachung ist der Ventilblock ohne Einzelheiten (z.B. Ventile, Pumpenmotor) gezeichnet. Das Gehäuse der Reglereinheit trägt eine Hutze 33 zur Aufnahme der Fahrdynamiksensoren und umfaßt einen integrierten elektrischen Stecker 17. Das Gehäuse der Regeleinheit wird mittels Schrauben 31 am Ventilblock befestigt, wobei in geeignet geformten Aussparungen des Reglergehäuses Positionierfedern 32 angeordnet sind. Wie in Teilbild b) dargestellt, kann durch Drehung beispielsweise der Schraube 31' eine Justage der Orientierung von Reglereinheit zu Ventilblock vorgenommen werden. Eine Verdrehung um Achse 34 läßt sich vornehmen, wenn der Schraubendurchmesser kleiner gewählt wird, als die Aufnahmeöffnung im Reglergehäuse für die Schrauben und der Innendurchmesser der Federn 32.

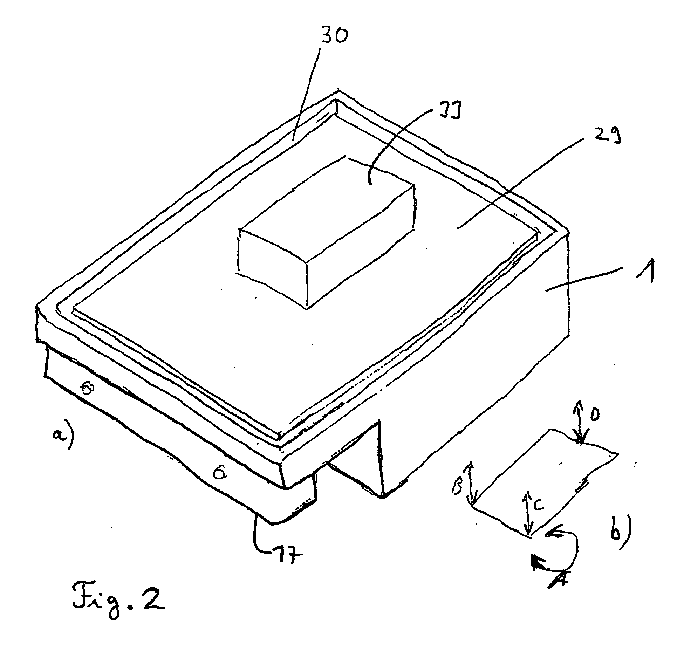

Die elektronische Regeleinheit in Fig. 2 läßt sich, wie weiter oben beschrieben, bezüglich des Ventilblocks justieren.

Die möglichen Justageeinrichtungen sind in Teilbild b) skizziert. Das Reglergehäuse der Regeleinheit in Teilbild a) ist zweiteilig mit einem Deckel 29 ausgeführt, mit dem Hutze 33 zur Aufnahme der Sensoren stoffschlüssig verbunden ist. Durch die zweiteilige Auslegung des Gehäuses kann ein umlaufender Zwischenraum 30 zwischen Deckel und Reglergehäuse vorgesehen werden, mit dem eine Justierung zwischen Deckel und Reglergehäuse erfolgen kann. Nach Abschluß der Justage kann eine Fixierung der Lage durch eine stoffschlüssig Verbindung von Deckel und Reglergehäuse erfolgen.

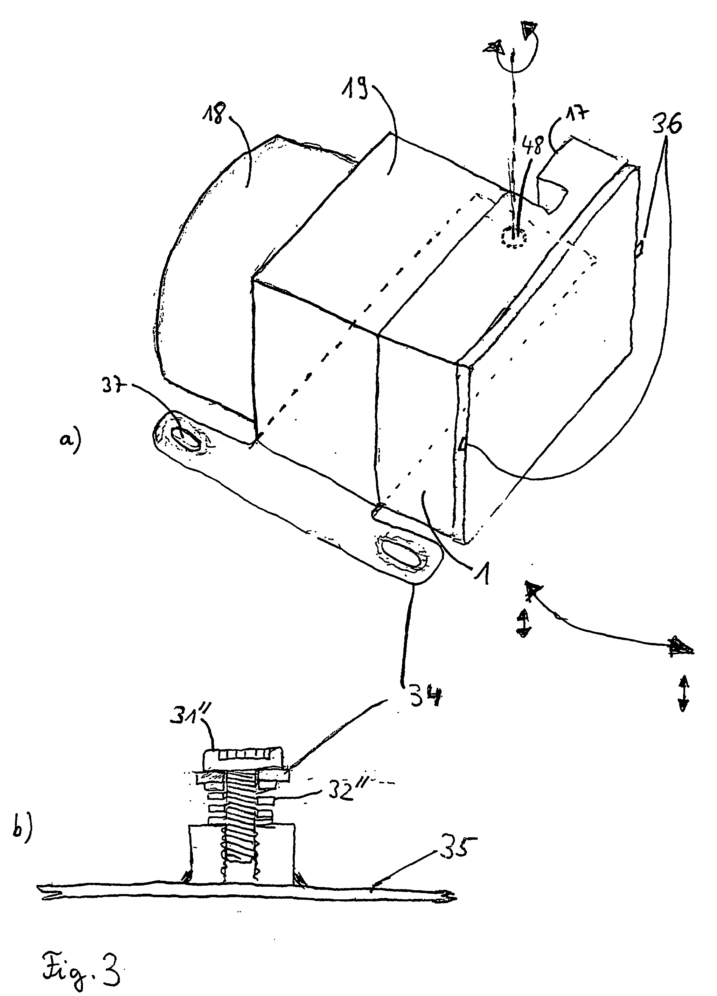

In Fig. 3 ist ein integriertes Steuergerät aus Ventilblock 19 mit angeflanschtem Pumpenmotor 18 und elektronischer Reglereinheit 1 dargestellt, welcher mittels eines Halters 34 an geeigneten Anlagepunkten der Fahrzeugkarosserie justierbar befestigt werden kann. Die Justage der Orientierung zwischen Ventilblock und Karosserie erfolgt zweckmäßigerweise mittels geeignet ausgelegter Schrauben 31" und Positionierfedern 32", wobei der Halter 34 Langlöcher 37 aufweist. Anstelle der Positionierfedern lassen sich auch Distanzspannringe einsetzen.

Zur Kontrolle der Einbaulage ist die erfindungsgemäße Vorrichtung zweckmäßigerweise mit Einbaumarkierungen versehen, die sich insbesondere am Reglergehäuse anbringen lassen.
Es kann außerdem zweckmäßig sein, das Reglergehäuse 1 mit einer oder mehreren Bohrungen 48 zu versehen, durch die sich beispielsweise mit einem Schraubendreher eine Justage der Sensoren bezüglich der Reglereinheit innerhalb des Reglergehäuses nach dem Zusammenbau durchführen läßt.

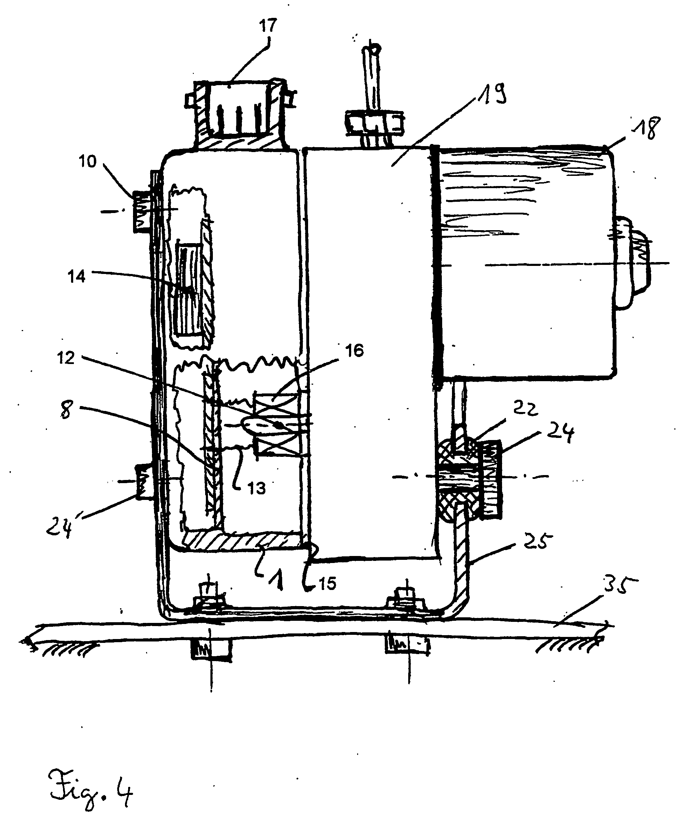

Ein weiteres Beispiel für eine integrierte Bremsvorrichtung ist in Fig. 4 dargestellt. Die Fahrdynamiksensoren sind zu einer Baugruppe 14 zusammengefaßt, welche im Gehäuse der Reglereinheit integriert ist. Die aus dem Ventilblock 19 in Richtung des Reglers vorstehenden Ventildome 12 werden von in der Reglereinheit angeordneten Ventilspulen 16 umschlossen (Magnetischer Stecker). Die Ventilspulen sind mittels elastischen, elektrisch leitfähigen und lösbaren Verbindungen 13 an die Leiterplatte 8 innerhalb des Reglers angeschlossen.
Die Übertragung von Erschütterungen und Vibrationen auf die Fahrdynamiksensoren, welche von Pumpenmotor und Ventilen hervorgerufen werden können und die Funktion der Fahrdynamiksensoren beeinträchtigen, lassen sich durch eine gedämpfte Befestigung der Fahrdynamiksensoren, des Reglergehäuses oder des Ventilblocks reduzieren. Im dargestellten Beispiel ist der Ventilblock über Schrauben 24 und Dämpfungselemente 22 elastisch an einem Halter 25 aufgehängt. Der Halter 25 ist fest mit der Karosserie verbunden. Halter 25 dient gleichzeitig zur Befestigung von Ventilblock 19, wobei dieser über Schrauben 24' nicht schwingungsgedämpft am Halter befestigt ist. Die elektronische Regeleinheit kann außerdem zusätzlich über einen Zwischenraum 15 vom Ventilblock abgekoppelt werden, welcher im einfachsten Fall ein flächenförmiger Zwischenraum ist, jedoch auch mit einem geeigneten Material gefüllt kann.

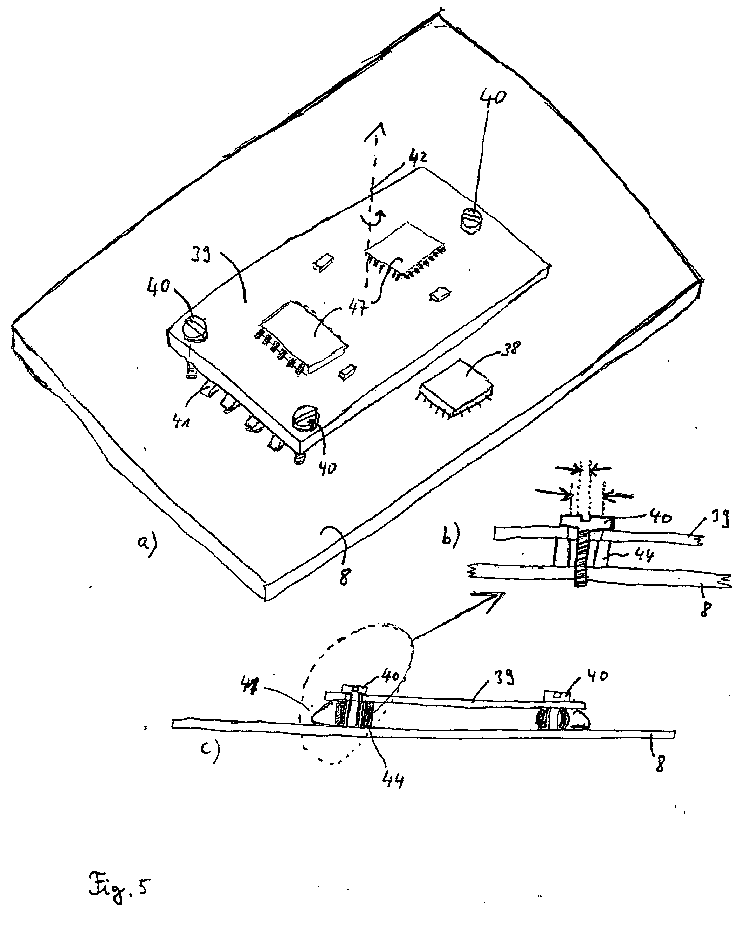

In Fig. 5 ist ein erfindungsgemäßer Träger 39 mit Sensorbauelementen 47 gezeigt, welcher justierbar an der Leiterplatte 8 für die Reglerbauelemente 38 befestigt ist. In Teilbild a) kann die Orientierung durch Justier- und Halteschrauben 40 innerhalb vorgegebener Grenzen eingestellt werden. Es ist aber ebenfalls möglich, nicht dargestellte Nagelstifte in das Leiterplattenmaterial einzudrücken, wobei auch hier der Abstand durch die Eindrücktiefe variiert werden kann. Vorteilhafterweise kann auch der Bereich unterhalb des Trägers 39 auf der Leiterplatte 8 mit elektronischen Bauelementen bestückt sein. Die elektrische Verbindung zwischen Sensoren und Leitplatte 8 kann über federnde Kontaktelemente 41 erfolgen.
Teilbild b) zeigt eine Justier- und Halteschraube im Querschnitt. Durch geeignete Dimensionierung der Bohrungen für die Schrauben kann auch eine Justage um die senkrecht zur Leiterplatte ausgerichtete Rotationsachse 42 vorgenommen werden.
In Teilbild c) sind federnde Elemente dargestellt, die zwischen Träger 39 und Leiterplatte 8 durch den Druck der Schrauben 40 eingeklemmt werden. Bei den federnden Elementen kann es sich um gummiartige Materialien 44 oder metallische Federn handeln, wobei diese Materialien zugleich eine leitfähige Verbindung herstellen können.

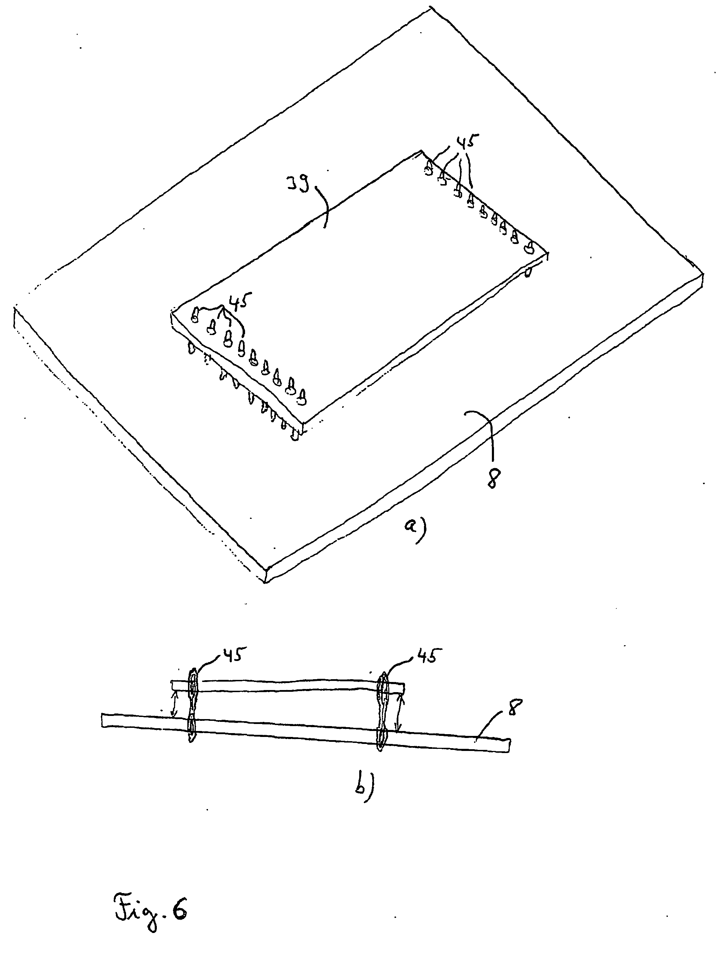

In Fig. 6 ist Träger 39 für die Fahrdynamiksensoren mittels Einpreßkontakten mit Leiterplatte 8 der elektronischen Regeleinheit verbunden. Hier kann eine Justage der Orientierung durch unterschiedliche Einpreßhöhen vorgenommen werden.

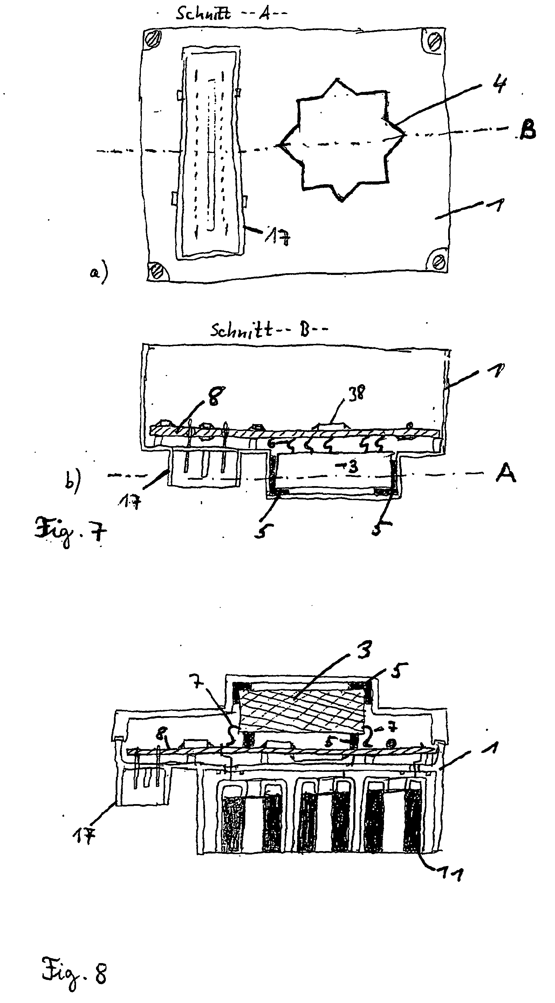

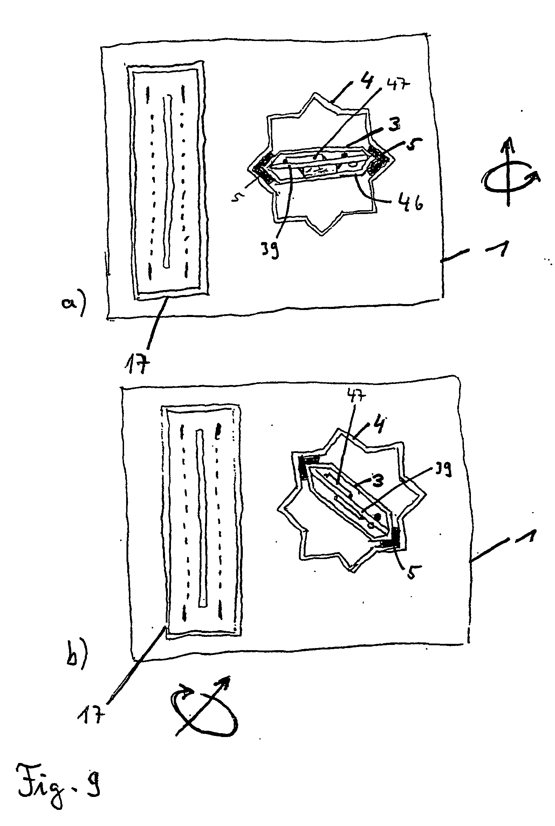

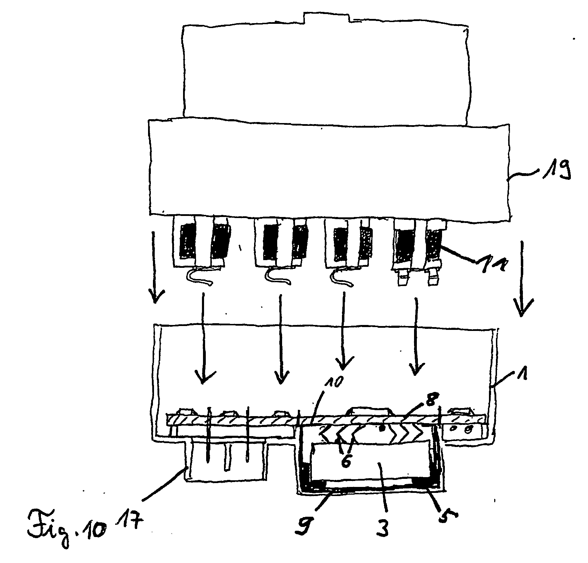

Die elektronische Reglereinheit 1 in Fig. 7 (Teilbild a) in Aufsicht; Teilbild b) im Querschnitt) ist mit einem Aufnahmemittel für die Fahrdynamiksensoren ausgestattet, welches den Einbau des Sensormoduls 3 in definierten Einbaulagen ermöglicht. Fig. 9 zeigt diese Ausführungsform mit eingesetztem Sensormodul 3 für unterschiedliche Einbaulagen gemäß Teilbildern a) und b). Das Sensormodul besteht aus einem Sensorgehäuse 46 mit auf einer Leiterplatte angeordneten Sensorbauelementen 47. Im dargestellten Beispiel ist das Aufnahmemittel eine sternförmige Ausnehmung 4 des Reglergehäuses, in die das Sensormodul je nach gewünschter Orientierung, zweckmäßigerweise mit Dämpfungselementen 5 elastisch gedämpft, eingesetzt werden kann. Die Kontaktierung der Sensorelemente erfolgt ähnlich wie die Kontaktierung der Ventilspulen über elastische Federkontaktelemente. Der elektrische Stecker 17 ist im Gegensatz zur Ausführungsform in Fig. 8 nach oben geführt.

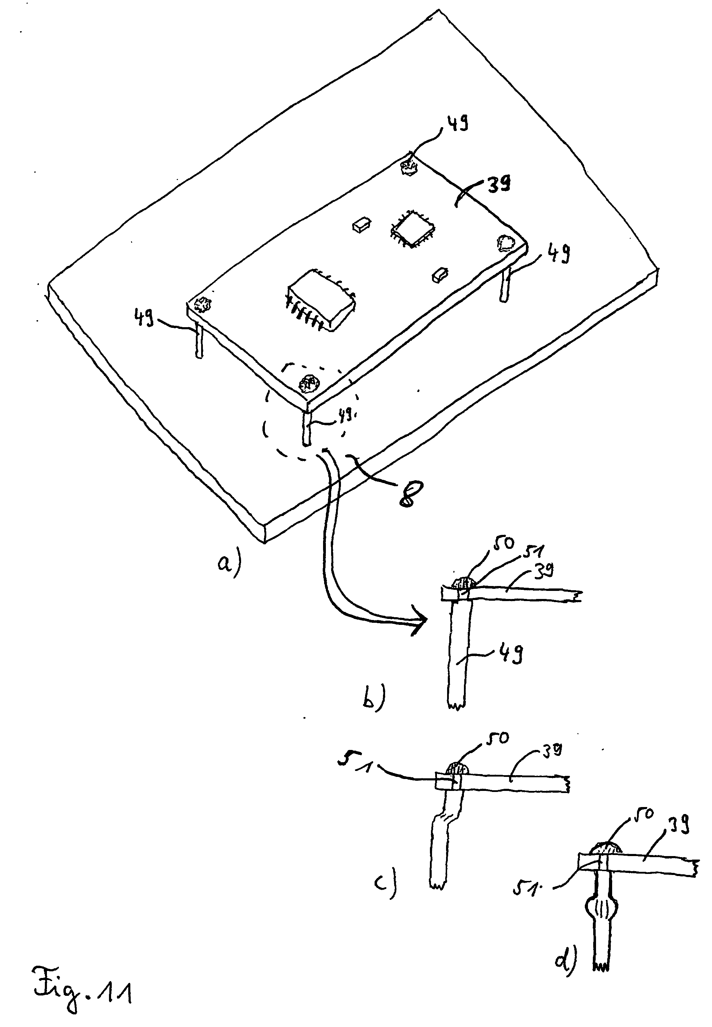

In Fig. 10 ist der Montagevorgang des Zusammenfügens von Ventilblock 19 und elektronischer Reglereinheit 1 dargestellt. Vor der Montage sind die Ventilspulen 11 auf nichtgezeichnete, aus dem Ventilblock herausstehende Ventildome aufgesteckt. An den Ventilspulen sind einseitig befestigte Kontaktelemente 13 angebracht, welche eine nach dem Zusammenfügen kraftbeaufschlagte lösbare Verbindungen mit geeignet metallisierten Flächen auf Leiterplatte 8 herstellen. Kontaktelemente 6 des Sensormoduls können in entsprechender Weise ausgeführt sein.
Mit Bezugszeichen 9 sind zur Abschirmung vorgesehene metallisierte Flächen auf dem vorzugsweise aus Kunststoff gefertigten Gehäuse der elektronischen Reglereinheit bezeichnet. Die das Sensormodul 3 im wesentlichen vollständig umhüllende Abschirmung wird durch metallisierte Flächen 10 aus Leiterbahnmaterial im Bereich der Leiterplatte fortgesetzt.

In Fig. 8 ist das Sensormodul 3 ebenfalls elastisch mittels Dämpfungselementen 5 gelagert. Im Gegensatz zu Fig. 7 sind hier zusätzliche Dämpfungselemente zwischen Sensormodul und Leiterplatte 8 angeordnet. Die Kontaktierung der Sensoren erfolgt über eine elastische leitfähige Verbindung, z.B. über flexible Leitungen, Bonddrähte, Flachbandleitungen etc.. Auf der dem Sensormodul gegenüberliegenden Seite der Leiterplatte sind im Gehäuse der Reglereinheit Ventilspulen 11 angeordnet.

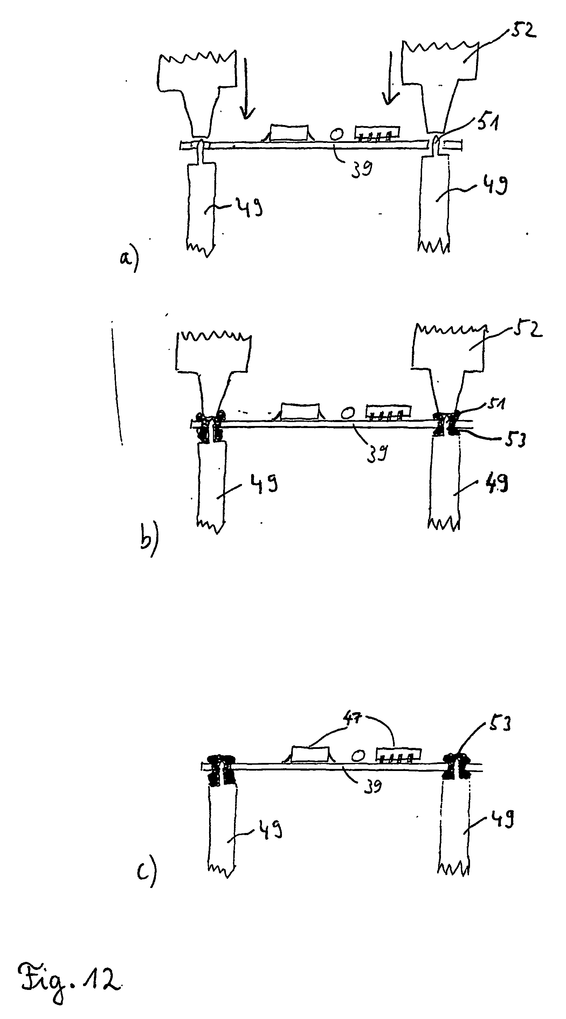

In Fig. 11, Teilbild a) ist ein besonders vorteilhaftes Beispiel zur Befestigung des Trägers 39 mit der Leiterplatte 8 mittels justierbarer länglicher Befestigungsmittel 49 dargestellt. Befestigungsmittel 49 bestehen aus einem Material, welches thermisch zur Durchführung der Justierung verformbar ist.
Gemäß Teilbild b) werden die thermisch verformbaren Stäbe 49, welche entsprechend auch mit der Leiterplatte verbunden sein können, über einen Verbindungspunkt 50 aus schmelzbarem Material oder einem Klebstoff mit Träger 39 verbunden, wobei zweckmäßigerweise stiftförmige Fortsätze 51 an der Stirnseite der Stäbe durch geeignete Bohrungen im gesteckt werden. Nach Aushärtung der Verbindungspunkte 50 werden die Stäbe 49 erhitzt, so daß diese erweichen und in durch das Material vorgegebenen Grenzen zur Justierung verformbar sind. Teilbild c) zeigt eine laterale Verformung eines Stabs, Teilbild. d) eine Stauchung eines Stabs in vertikale Richtung.
Der Justiervorgang wird mit dem Erkalten lassen der Stäbe abgeschlossen, wodurch die justierte Orientierung des Trägers gegenüber der Leiterplatte fixiert wird.
Die notwendigen elektrischen Verbindungen zwischen Träger und Leiterplatte lassen sich bei dem hier dargestellten Beispiel besonders zweckmäßig mittels flexibler Leiterbahnen ausführen.

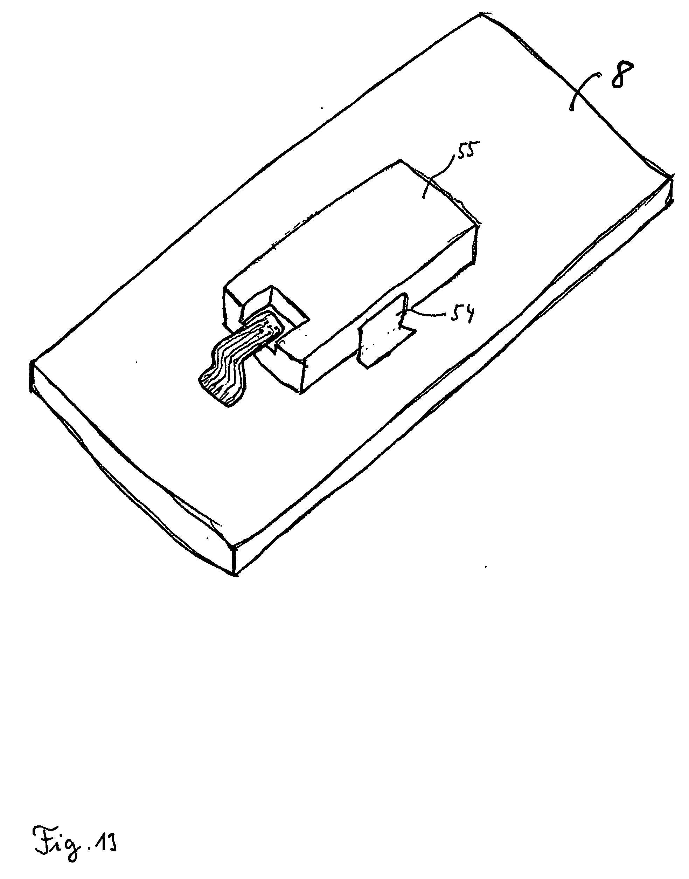

In Fig. 12 ist ein Beispiel für ein Verfahren zur maschinellen Montage eines Trägers 39 auf der nichtgezeichneten Leiterplatte 8 dargestellt. Zunächst wird mittels einer Zuführungseinrichtung 52 ein Träger 39 an die mit der Leiterplatte verbundenen Stäbe 49 herangeführt, welche den Träger beispielsweise mittels einer nicht dargestellten Saugeinrichtung festhält, und anschließend auf den bereits beschriebenen Fortsätzen 51' abgesetzt. Danach wird mittels eines Dispenser ein thermoplastisches, ein schmelzbares metallisches Material 53 so aufgespritzt, daß eine stoffschlüssige Verbindung zwischen Stäben 49 und Träger 39 entsteht. Die im Träger vorgesehenen Bohrungen zur Aufnahme der Fortsätze 51 haben zweckmäßigerweise einen größeren Durchmesser, als die Fortsätze, so daß der Trägern nach dessen Befestigung durch Erwärmung des Materials 53, zum Beispiel unter Verwendung von Heizstrahlern, justiert werden kann.
Wenn keine Nachjustierung in der vorstehend beschriebenen Weise durchgeführt wird, kann als Material 53 auch ein Klebstoff eingesetzt werden.

Eine weiteres bevorzugtes Ausführungsbeispiel betreffend die Befestigung eines Halters für Fahrdynamiksensoren mit Leiterplatte 8 der elektronischen Reglereinheit ist in Fig. 13 dargestellt. Die Befestigung des Sensorgehäuses 55 erfolgt mittels durch Löten lösbarer und justierbarer Halter, Winkel 54 oder Bleche, die so geformt sind, daß das Sensormodul 55 in diese eingesetzt werden kann. Die Oberfläche des Sensormoduls 55 ist zweckmäßigerweise mit einem metallischen Material beschichtet oder besteht aus einem solchen. Hierdurch kann eine flächenförmige Lötverbindungen mit den Haltern erreicht werden. Durch Erhitzen der Lötverbindungen und gegenseitiges Verschieben der über die Kontaktflächen verbundenen Flächen läßt sich eine Justage des Sensormoduls bezüglich Leiterplatte 8 durchführen.

## Patentansprüche

1. Vorrichtung zur Fahrdynamikregelung bestehend aus einem Ventilblock (19) und einer damit verbundenen elektronischen Reglereinheit (1), wobei innerhalb der Reglereinheit elektronische Bauelemente (38) zumindest für den Bremseneingriff angeordnet sind, die Signale von mindestens einem Fahrdynamiksensor (3,14,47), wie Gierratensensor und/oder Beschleunigungssensor, verarbeiten und wobei im Ventilblock zumindest elektrohydraulische Ventile angeordnet sind, **dadurch gekennzeichnet, daß** mindestens ein Fahrdynamiksensor in der elektronischen Reglereinheit oder dem Ventilblock integriert ist, wobei dieser insbesondere mit dem Gehäuse der elektronischen Reglereinheit mechanisch verbunden ist oder von diesem umschlossen wird.

2. Vorrichtung nach Anspruch 1, **dadurch gekennzeichnet, daß** ein Justiermittel vorhanden ist, mit dem eine Fehlorientierung des oder der Fahrdynamiksensoren bezüglich den Fahrzeugachsen korrigiert werden kann.

3. Vorrichtung nach Anspruch 2, **dadurch gekennzeichnet, daß** das Justiermittel ein justierbares Befestigungsmittel (30,31,32,37,40,44,45,49) und/oder ein elektronisches Korrekturmittel ist.

4. Vorrichtung nach Anspruch 1 bis 3, **dadurch gekennzeichnet, daß** der oder die Fahrdynamiksensoren auf einem gemeinsamen Träger (39) angeordnet sind, welcher elektrisch mit einem Träger für die Bauelemente der elektronischen Reglereinheit (8) verbunden ist.

5. Vorrichtung nach Anspruch 4, **dadurch gekennzeichnet, daß** der oder die Fahrdynamiksensoren innerhalb eines zumindest überwiegend abgeschlossenen Sensorgehäuses (3) angeordnet sind.

6. Vorrichtung nach mindestens einem der Ansprüche 1 bis 5, **dadurch gekennzeichnet, daß** das Sensorgehäuse oder der Träger für die Fahrdynamiksensoren in ein Aufnahmemittel (4) des Gehäuses der Reglereinheit oder des Bauelementeträgers der Reglereinheit eingesetzt ist, welches eine Aufnahme der Fahrdynamiksensoren in vordefinierten Einbauorientierungen ermöglicht.

7. Vorrichtung nach mindestens einem der Ansprüche 1 bis 6, **dadurch gekennzeichnet, daß** das Sensorgehäuse oder der Träger für die Fahrdynamiksensoren in der Vorrichtung zur Fahrdynamikregelung mittels Dämpfungselementen (5,44) elastisch mechanisch fixiert ist.

8. Vorrichtung nach mindestens einem der Ansprüche 1 bis 7, **dadurch gekennzeichnet, daß** die Verbindung zwischen Sensorgehäuse oder dem Träger für die Fahrdynamiksensoren und der Vorrichtung zur Fahrdynamikregelung mittels elastischer elektrisch leitfähiger Kontaktelemente (6) erfolgt oder mittels thermisch verformbarer Halter (49).

9. Vorrichtung nach mindestens einem der Ansprüche 1 bis 8, **dadurch gekennzeichnet, daß** das Sensorgehäuse und/oder das Gehäuse der Reglereinheit und/oder die Leiterplatte in der Reglereinheit zumindest im Bereich der Sensoren eine elektrische Schirmung (9,10) aufweist.

10. Vorrichtung nach mindestens einem der Ansprüche 1 bis 9, **dadurch gekennzeichnet, daß** elektronische Filtermittel vorgesehen sind, welche den Einfluß von unerwünschten Beschleunigungen, wie z.B. Vibrationen etc., auf die Fahrdynamiksensoren unterdrücken.

11. Vorrichtung nach mindestens einem der Ansprüche 1 bis 10, **dadurch gekennzeichnet, daß** die elektronischen Korrekturmittel zur Justage von Fehlorientierungen Korrekturalgorithmen sind, die in einem elektronischen Rechenwerk der Vorrichtung ausgeführt werden.

12. Vorrichtung nach mindestens einem der Ansprüche 1 bis 11, **dadurch gekennzeichnet, daß** das justierbare Befestigungsmittel mindestens eine mechanische Einrichtung zur Justage der Orientierung aus der Gruppe
- Einrichtungen zur Justage zwischen Ventilblock und Reglereinheit (31,32),
- Einrichtungen zur Justage zwischen Ventilblock und Fahrzeugkarosserie (31",32"),
- Einrichtungen zur Justage zwischen Sensorgehäuse oder Träger für die Fahrdynamiksensoren und Reglergehäuse (30) und
- Einrichtungen zur Justage zwischen Sensorgehäuse oder Träger für die Fahrdynamiksensoren und einem Bauelementträger der Reglereinheit (40,44,45),
umfaßt.

13. Vorrichtung nach Anspruch 12, **dadurch gekennzeichnet, daß** die Einrichtung zur Justage distanzeinstellende Schraubverbindungen (31,31",32,32") und/oder höhenverstellbare elektrisch leitende Einpreßkontakte (45) und/oder thermisch verformbare Halter (49) umfaßt.

14. Vorrichtung nach Anspruch 12 oder 13, **dadurch gekennzeichnet, daß** mittels einer stoffschlüssigen Verbindung oder durch thermoplastische Aushärtung eine endgültige Fixierung der Sensororientierung nach der Justage erfolgt.

15. Vorrichtung nach mindestens einem der Ansprüche 12 bis 14, **dadurch gekennzeichnet, daß** die distanzeinstellenden Schraubverbindungen Gummielemente (44) und/oder Federelemente (32,32") umfassen.

16. Vorrichtung nach mindestens einem der Ansprüche 1 bis 15, **dadurch gekennzeichnet, daß** die Fahrdynamiksensoren vom Ventilblock über mindestens einen Schwingungsdämpfer (22) zum Schutz vor Vibrationen des Ventilblocks oder des Pumpenmotors abgekoppelt sind.

17. Verfahren zur Orientierung von einem oder mehreren Fahrdynamiksensoren, wie Gierratensensoren und/oder Beschleunigungssensoren, welche in eine Vorrichtung zur Fahrdynamikregelung, nach mindestens einem der Ansprüche 1 bis 16, integriert sind, wobei die Vorrichtung aus einem Ventilblock (19) und einer elektronischen Reglereinheit (1) besteht und innerhalb der Reglereinheit elektronische Bauelemente zumindest für den Bremseneingriff angeordnet sind, die Signale des oder der Fahrdynamiksensoren verarbeiten und wobei die sensorisch empfindlichen Achsen der Fahrdynamiksensoren gegenüber den Fahrzeugachsen nach dem Einbau in ein Kraftfahrzeug eine Fehlorientierung aufweisen können (aktuelle Sensoreinbauachsen), **gekennzeichnet durch** die Schritte:
- Drehen und/oder Beschleunigen der Vorrichtung, in die der Sensor eingebaut ist, um eine oder mehrere festgelegte Achsen und/oder in festgelegte Richtungen,
- Messen von Sensorsignalen während des Drehens bzw. Beschleunigens um diese Achsen und/oder Richtungen,
- Berechnen der Winkeldifferenzen zwischen den aktuellen Sensoreinbauachsen/-richtungen und den festgelegten Achsen/Richtungen **durch** Vergleich der gemessenen Sensorsignale mit den theoretisch erwarteten Sensorsignalen und
- Korrigieren der Fehlorientierung nach dem Einbau der Fahrdynamiksensoren an Hand der berechneten Winkeldifferenzen mittels eines Korrekturmittels.

18. Verfahren nach Anspruch 17, **dadurch gekennzeichnet, daß** das Korrekturmittel ein Justiermittel nach mindestens einem der Ansprüche 3 oder 11 bis 15 ist.

19. Verfahren nach Anspruch 17, **dadurch gekennzeichnet, daß** das Korrekturmittel Berechnungsschritte im Rechenwerk der elektronischen Reglereinheit zur Korrektur der Sensordaten sind.

## Claims

1. Device for driving dynamics control comprising a valve block (19) and an electronic controller unit (1) connected thereto, wherein electronic components (38) at least for braking intervention are arranged within the controller unit and process signals of at least one driving dynamics sensor (3, 14, 47), such as a yaw rate sensor and/or acceleration sensor, and wherein at least electrohydraulic valves are arranged in the valve block,
**characterized in that** at least one driving dynamics sensor is integrated in the electronic controller unit or the valve block, said sensor being mechanically coupled especially to the housing of the electronic controller unit, or being enclosed by it.

2. Device as claimed in claim 1,
**characterized in that** there is provision of an adjusting means rendering it possible to correct a misalignment of the driving dynamics sensor(s) in relation to the vehicle axles.

3. Device as claimed in claim 2,
**characterized in that** the adjusting means is an adjustable fixing means (30, 31, 32, 37, 40, 44, 45, 49) and/or an electronic correction means.

4. Device as claimed in claims 1 to 3,
**characterized in that** the driving dynamics sensor(s) is(are) arranged on a joint carrier (39) that is connected electrically to a carrier for the components of the electronic controller unit (8).

5. Device as claimed in claim 4,
**characterized in that** the driving dynamics sensor(s) is(are) accommodated within a sensor housing (3) that is closed at least to a major extent.

6. Device as claimed in at least one of claims 1 to 5,
**characterized in that** the sensor housing or the carrier for the driving dynamics sensors is inserted into an accommodation means (4) of the housing of the controller unit or the components carrier of the controller unit, said means permitting accommodation of the driving dynamics sensors in predefined installation positions.

7. Device as claimed in at least any one of claims 1 to 6,
**characterized in that** the sensor housing or the carrier for the driving dynamics sensors is fixed in the device for driving dynamics control in an elastical mechanical fashion by means of damping elements (5, 44).

8. Device as claimed in at least any one of claims 1 to 7,
**characterized in that** the connection between the sensor housing or the carrier for the driving dynamics sensors and the device for driving dynamics control is provided by means of elastic, electrically conductive contact elements (6) or by means of thermally deformable holders (49).

9. Device as claimed in at least any one of claims 1 to 8,
**characterized in that** the sensor housing, and/or the housing of the controller unit, and/or the printed circuit board in the controller unit includes an electrical shielding screen (9, 10) at least in the area of the sensors.

10. Device as claimed in at least any one of claims 1 to 9,
**characterized in that** electronic filtering means are provided, suppressing the effect of undesirable accelerations such as vibrations, etc., on the driving dynamics sensors.

11. Device as claimed in at least any one of claims 1 to 10,
**characterized in that** the electronic correction means for the adjustment of misalignments are correction algorithms that are implemented in an electronic arithmetic unit of the device.

12. Device as claimed in at least any one of claims 1 to 11,
**characterized in that** the adjustable fixing means comprise at least one mechanical device for adjusting the alignment out of the group of
- devices for the adjustment between valve block and controller unit (31, 32),
- devices for the adjustment between valve block and vehicle body (31", 32''),
- devices for the adjustment between sensor housing or carrier for the driving dynamics sensors and controller housing (30), and
- devices for the adjustment between sensor housing or carrier for the driving dynamics sensors and a components carrier of the controller unit (40, 44, 45).

13. Device as claimed in claim 12,
**characterized in that** the device for the adjustment comprises distance-adjusting screw couplings (31, 31", 32, 32''), and/or level-adjustable, electrically conductive press-in contacts (45), and/or thermally deformable holders (49).

14. Device as claimed in claim 12 or 13,
**characterized in that** the sensor alignment is finally fixed after the adjustment by means of a molecular bond or by thermoplastic solidification.

15. Device as claimed in at least any one of claims 12 to 14,
**characterized in that** the distance-adjusting screw couplings comprise rubber elements (44) and/or spring elements (32, 32").

16. Device as claimed in at least any one of claims 1 to 15,
**characterized in that** the driving dynamics sensors are uncoupled from the valve block by way of at least one vibration damper (22) for protecting against vibrations of the valve block or the pump motor.

17. Method of aligning one or more driving dynamics sensors, such as yaw rate sensors and/or acceleration sensors, which are integrated into a device for driving dynamics control, as claimed in at least any one of claims 1 to 16, wherein the device is composed of a valve block (19) and an electronic controller unit (1), and electronic components at least for braking intervention are arranged within the controller unit and process signals of the driving dynamics sensor(s), and wherein the sensorially sensitive axes of the driving dynamics sensors in relation to the vehicle axles may have a misalignment after the installation into a motor vehicle (current sensor installation axes),
**characterized by** the steps of:
- rotation and/or acceleration of the device into which the sensor is mounted, about one or more determined axes and/or in determined directions,
- measurement of sensor signals during the rotation or acceleration about these axes and/or directions,
- calculation of the angular differences between the current sensor installation axes/directions and the determined axes/directions by comparing the measured sensor signals with the theoretically expected sensor signals, and
- correction of the misalignment after the installation of the driving dynamics sensors by way of the calculated angular differences using a correction means.

18. Method as claimed in claim 17,
**characterized in that** the correction means is an adjusting means as claimed in at least any one of claims 3 or 11 to 15.

19. Method as claimed in claim 17,
**characterized in that** the correction means concerns steps of calculation in the arithmetic unit of the electronic controller unit for the correction of the sensor data.

## Revendications

1. Dispositif pour la régulation de la dynamique de marche constitué d'un bloc-soupapes (19) et d'une unité électronique de régulation (1) reliée à celui-ci, à l'intérieur de l'unité de régulation étant disposés des composants électroniques (38) au moins pour l'intervention du freinage, lesquels traitent des signaux d'au moins un capteur de dynamique de marche (3, 14, 47), tel qu'un capteur d'embardée et/ou capteur d'accélération, et dans le bloc-soupapes étant disposées au moins des soupapes électro-hydrauliques, **caractérisé en ce qu'**au moins un capteur de dynamique de marche est intégré à l'unité électronique de régulation ou au bloc-soupapes, ce dernier en particulier étant relié mécaniquement au boîtier de l'unité électronique de régulation ou enfermé par celui-ci.

2. Dispositif selon la revendication 1, **caractérisé en ce qu'**il est prévu un moyen d'ajustement par lequel on peut corriger un défaut d'orientation du ou des capteurs de dynamique de marche par rapport aux axes du véhicule.

3. Dispositif selon la revendication 2, **caractérisé en ce que** le moyen d'ajustement est un moyen de fixation ajustable (30, 31, 32, 37, 40, 44, 45, 49) et/ou un moyen électronique de correction.

4. Dispositif selon les revendications 1 à 3, **caractérisé en ce que** le ou les capteurs de dynamique de marche sont disposés sur un support (39) commun qui est relié électriquement à un support des composants de l'unité électronique de régulation (8).

5. Dispositif selon la revendication 4, **caractérisé en ce que** le ou les capteurs de dynamique de marche sont disposés à l'intérieur d'un boîtier de capteur (3) au moins principalement fermé.

6. Dispositif selon l'une au moins des revendications 1 à 5, **caractérisé en ce que** le boîtier de capteur ou le support pour les capteurs de dynamique de marche sont insérés dans un moyen de réception (4) du boîtier de l'unité de régulation ou du support de composants de l'unité de régulation, lequel moyen de réception permet de recevoir les capteurs de dynamique de marche dans des orientations de montage prédéfinies.

7. Dispositif selon l'une au moins des revendications 1 à 6, **caractérisé en ce que** le boîtier de capteur ou le support des capteurs de dynamique de marche sont fixés mécaniquement et élastiquement dans le dispositif de régulation de la dynamique de marche, au moyen d'éléments d'amortissement (5, 44).

8. Dispositif selon l'une au moins des revendications 1 à 7, **caractérisé en ce que** la liaison entre le boîtier de capteur ou le support des capteurs de dynamique de marche et le dispositif de régulation de la dynamique de marche s'effectue au moyen d'éléments de contact (6) électriquement conducteurs ou au moyen d'appuis (49) thermiquement déformables.

9. Dispositif selon l'une au moins des revendications 1 à 8, **caractérisé en ce que** le boîtier de capteur et/ou le boîtier de l'unité de régulation et/ou la plaquette de circuits imprimés dans l'unité de régulation comportent un blindage électrique (9, 10) au moins dans la zone des capteurs.

10. Dispositif selon l'une au moins des revendications 1 à 9, **caractérisé en ce que** sont prévus des moyens électroniques de filtrage qui suppriment l'influence d'accélérations indésirables, telles que par exemple des vibrations, etc., sur les capteurs de dynamique de marche.

11. Dispositif selon l'une au moins des revendications 1 à 10, **caractérisé en ce que** les moyens électroniques de correction pour l'ajustage d'orientations défectueuses sont des algorithmes de correction qui sont réalisés dans un calculateur électronique du dispositif.

12. Dispositif selon l'une au moins des revendications 1 à 11, **caractérisé en ce que** le moyen de fixation ajustable comprend au moins un dispositif mécanique pour l'ajustage de l'orientation du groupe
- dispositifs d'ajustage entre le bloc-soupapes et l'unité de régulation (31, 32),
- dispositifs d'ajustage entre le bloc-soupapes et la carrosserie du véhicule (31", 32"),
- dispositifs d'ajustage entre le boîtier de capteur ou le support des capteurs de dynamique de marche et le boîtier de régulateur (30), et
- dispositifs d'ajustage entre le boîtier de capteur ou le support des capteurs de dynamique de marche et un porte-composant de l'unité de régulation (40, 44, 45).

13. Dispositif selon la revendication 12, **caractérisé en ce que** le dispositif d'ajustage comprend des liaisons à vis (31, 31", 32, 32") réglant l'écartement et/ou des contacts à enfoncement (45) électriquement conducteurs et réglables en hauteur et/ou des appuis (49) déformables thermiquement.

14. Dispositif selon la revendication 12 ou 13, **caractérisé en ce qu'**une fixation définitive de l'orientation des capteurs s'effectue après l'ajustage au moyen d'une liaison par adhérence de matière ou par durcissement thermoplastique.

15. Dispositif selon l'une au moins des revendications 12 à 14, **caractérisé en ce que** les liaisons à vis réglant l'écartement comprennent des éléments en caoutchouc (44) et/ou des éléments à ressort (32, 32").

16. Dispositif selon l'une au moins des revendications 1 à 15, **caractérisé en ce que** les capteurs de dynamique de marche du bloc-soupapes sont désaccouplés du bloc-soupapes ou du moteur de la pompe par au moins un amortisseur d'oscillations (22) pour la protection contre les vibrations.

17. Procédé d'orientation d'un ou de plusieurs capteurs de dynamique de marche, tels que des capteurs d'embardée et/ou capteurs d'accélération, qui sont intégrés dans un dispositif de régulation de la dynamique de marche, selon l'une au moins des revendications 1 à 16, le dispositif étant constitué d'un bloc-soupapes (19) et d'une unité électronique de régulation (1) et à l'intérieur de l'unité de régulation étant disposés des composants électroniques au moins pour l'intervention du freinage, lesquels traitent des signaux du ou des capteurs de dynamique de marche et les axes sensibles à la détection des capteurs de dynamique de marche pouvant présenter, par rapport aux axes du véhicule, après montage dans un véhicule automobile, une orientation défectueuse (axes actuels des capteurs), **caractérisé par** les étapes suivantes:
- rotation et/ou accélération du dispositif dans lequel est monté le capteur, autour d'un ou de plusieurs axes définis et/ou dans des directions définies,
- mesure de signaux des capteurs pendant la rotation ou l'accélération autour de ces axes ou directions,
- calcul des différences angulaires entre les axes/directions actuels de montage des capteurs et les axes/directions définis, par comparaison des signaux mesurés des capteurs et des signaux théoriques probables des capteurs et
- correction de l'orientation défectueuse après montage des capteurs de dynamique de marche à l'aide des écarts angulaires calculés, avec un moyen de correction.

18. Procédé selon la revendication 17, **caractérisé en ce que** le moyen de correction est un moyen d'ajustage selon l'une au moins des revendications 3 ou 11 à 15.

19. Procédé selon la revendication 17, **caractérisé en ce que** le moyen de correction est constitué d'étapes de calcul dans le calculateur de l'unité électronique de régulation, pour la correction des données des capteurs.
